# FASCICULE DE BREVET EUROPEEN

(11) **EP 0 814 562 B1**
(45) Date de publication et mention de la délivrance du brevet: **20.02.2002**
(21) Numéro de dépôt: 97401295.7
(22) Date de dépôt: 09.06.1997
(51) Int. Cl.: H03K 3/03, H03K 5/13

(54) **Procédé pour obtenir un signal à fréquence variable et cellule à retard variable adaptée à la mise en oeuvre de ce procédé**
Verfahren zur Erzeugung einer variablen Frequenz und variabele Verzögerungszelle zur Durchführung des Verfahrens
Method for obtaining a variable frequency and variable delay cell for carrying out this method

(30) Priorité: 19.06.1996 FR 9607604
(43) Date de publication de la demande: 29.12.1997
(73) Titulaire: BULL S.A., 78430 Louveciennes (FR)
(72) Inventeur: Boudry, Jean-Marie, 78650 Beynes (FR)

(56) Documents cités:
- EP-A- 0 601 780
- JP-A- 63 185 108
- US-A- 5 063 311
- US-A- 5 250 914
- US-A- 5 459 437
- US-A- 5 481 207
- US-A- 5 525 938
- J. RAMIREZ-ANGULO: "A COMPACT CURRENT CONTROLLED CMOS WAVEFORM GENERATOR" IEEE TRANSACTIONS ON CIRCUITS AND SYSTEMS, vol. 39, no. 12, 1 décembre 1992, NEW YORK,US, pages 883-885, XP000361005
- D. JEONG: "DESIGN OF PLL BASED CLOCK GENERATION CIRCUITS" IEEE JOURNAL OF SOLID STATE CIRCUITS, vol. 22, no. 2, 1 avril 1987, NEW YORK,US, pages 255-261, XP002027247

## Description

Le domaine de l'invention est celui des oscillateurs à fréquence variable réalisés à l'aide d'une boucle comprenant un nombre impair de cellules inverseuses montées en série. Parmi les cellules inverseuses de la boucle, certaines sont à retard variable. La commande de ce retard agit directement sur la valeur de la fréquence. De telles cellules peuvent être utilisées dans d'autres applications telles que la synchronisation de signaux.

Selon l'état de la technique, le signal de commande fait varier un front de changement d'état du signal de sortie d'une cellule sur changement d'état du signal d'entrée. Un front raide permet d'obtenir un retard faible. Un front de pente faible permet d'obtenir un retard plus important. On obtient un signal oscillant dont la demi-période est égale à la somme des retards de chaque cellule. Pour obtenir des fréquences élevées, par exemple supérieures au GHz, de telles cellules présentent un inconvénient car il devient difficile de réduire leur nombre dans une boucle, tout en maintenant une plage de variation de fréquence suffisante pour palier les problèmes de dispersion de fabrication et les dérives en tension et en température. En effet, un nombre minimal de cellules inverseuses est nécessaire pour garantir que le signal de sortie d'une cellule atteint un niveau bas ou haut extrême avant que son signal d'entrée ne s'inverse. La période minimale obtenue par l'addition des retards intrinsèques de chaque cellule limite alors la fréquence maximale que l'on puisse obtenir.

Dans l'abrégé de la publication japonaise JP-A-63185108, un signal est inversé puis utilisé pour une inversion suivante. En répétant cette opération un nombre impair de fois et en rebouclant le dernier signal obtenu sur le premier signal, le signal ainsi inversé oscille à une fréquence égale à l'inverse du double de la somme des retards sur chaque inversion de signal. Le retard sur une inversion de signal résulte d'une valeur de tension Vctl qui contrôle une largeur d'hystéresis sur le changement d'état du signal inversé. La tension Vctl doit y être prévue de façon à pouvoir fournir un courant appelé par un transistor 9 en combinaison avec un transistor 8, lors d'un changement d'état du signal inversé. La plage de variation de l'hystérésis y est limitée par le dimensionnement du transistor 8. L'objet de l'invention est de procurer une oscillation à fréquence élevée, variable dans une plage appréciable.

Pour obtenir un signal à fréquence variable, l'invention propose un procédé rebouclant sur lui-même un signal inversé un nombre impair de fois avec un retard commandé par un signal de contrôle, caractérisé en ce qu'une inversion du dit signal inversé est faite avec un gain de valeur commandée par le signal de contrôle et en ce que le signal extrait rétroagit sur le signal de contrôle pour donner au signal extrait une hystérésis de largeur fonction du signal de contrôle.

L'objet de l'invention est aussi une cellule à retard variable dont le temps de transition entre deux états proches des extrêmes est minimal, quel que soit le retard contrôlé dans une plage appréciable, par exemple d'étendue 1 à 16.

L'invention propose une cellule pour obtenir un signal extrait avec un retard variable sur un signal d'entrée au moyen d'un amplificateur inverseur dont le gain est commandé par un signal de contrôle, caractérisée en ce que le signal extrait agit en contre réaction sur la valeur du gain pour provoquer une hystérésis sur le changement d'état du dit signal extrait.

Différents affinements de l'invention ressortiront de la description qui va suivre en référence aux figures.
La figure 1 représente un oscillateur de l'état de la technique.
Les figures 2a et 2b représentent des cellules à retard utilisables pour réaliser un oscillateur conforme à celui de la figure 1.
La figure 3 représente un premier exemple de cellule à retard conforme à l'invention.
La figure 4 représente une mise en cascade possible de cellules conformes à l'invention.
La figure 5 représente un oscillateur conforme à l'invention.
Les figures 6 à 9 représentent des caractéristiques courant tension de transistors MOS pour différentes valeurs de tensions de grille pour le premier exemple de cellule à retard.
La figure 10 représente un deuxième exemple de cellule à retard conforme à l'invention.
Les figures 11 et 12 représentent des caractéristiques courant tension de transistors MOS pour différentes valeurs de tensions de grille pour le deuxième exemple de cellule à retard conforme à l'invention.

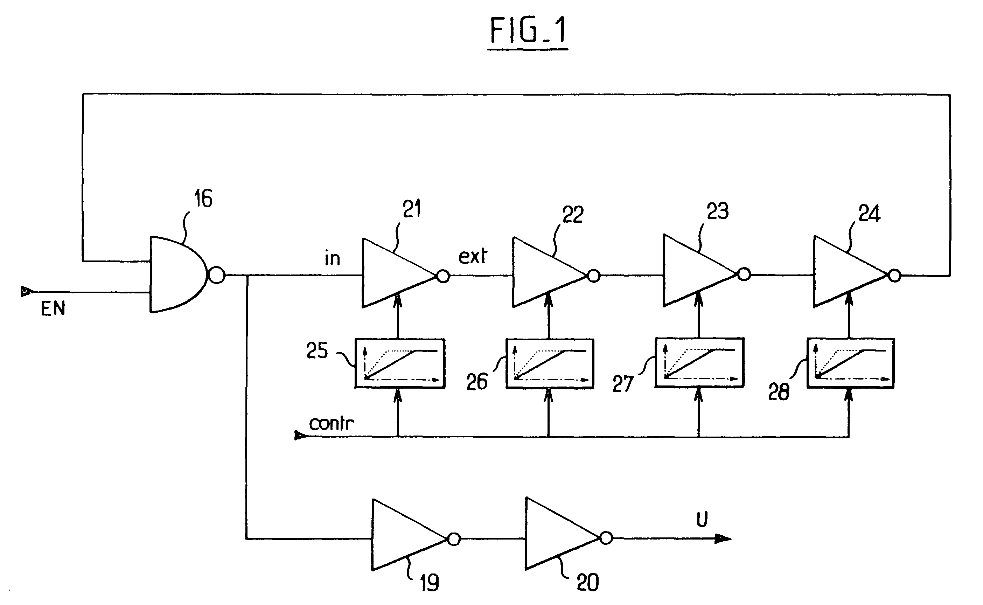

La figure 1 représente un oscillateur de l'état de la technique. Cet oscillateur comprend un nombre impair de portes inverseuses 16, 21, 22, 23, 24 telles qu'une entrée de chaque porte est alimentée par une sortie de la porte précédente, l'entrée de la première porte 16 étant alimentée par la sortie de la dernière porte 24. Chaque porte 21, 22, 23, 24 fournit un signal ext inversé par rapport à un signal d'entrée in. Chaque porte 21, 22, 23, 24 possède un gain 25, 26, 27, 28 variable commandé par un signal contr. Le gain est représenté par l'évolution temporelle du signal ext suite à une descente sur un front raide du signal in. On y distingue une première partie à gradient positif symbolisant le temps de montée du signal ext et une deuxième partie à gradient nul symbolisant l'atteinte de l'état stable du signal ext. Un signal contr permet de faire varier la pente de la première partie. Un signal contr faible permet d'obtenir une pente faible et un signal contr fort permet d'obtenir une pente forte. Le retard τ du signal ext sur le signal in sera d'autant plus fort que la pente sera faible. Il est donc possible de faire varier le retard de chaque porte inverseuse 21, 22, 23, 24 en faisant varier le signal contr. Suivant l'exemple de la figure 1 avec quatre portes identiques, le signal in en entrée de la porte 21 se retrouve alors en entrée de la porte 16 avec un retard commandé par le signal contr égal à 4τ. La porte 16 est une porte NAND dont une entrée est alimentée par un signal EN de mise en service de l'oscillateur. Si le retard intrinsèque de la porte 16 est τ', la mise à 1 du signal EN permet d'inverser le signal in introduit dans la porte 21 avec un retard T=4τ+τ'. Ceci crée une instabilité qui fait osciller le signal in avec une fréquence égale à 1/2T. En augmentant le nombre de portes inverseuses, on obtient de plus grandes valeurs de T et donc des fréquences plus basses. Pour un nombre fixé de portes inverseuses, il est possible d'obtenir des fréquences basses avec des valeurs basses du signal contr et des fréquences plus élevées avec des valeurs élevées du signal contr.

Le signal in introduit dans la porte 21 est également introduit dans une succession de deux inverseurs 19, 20 de façon à pouvoir sortir vers l'extérieur un signal U oscillant à la fréquence désirée.

L'oscillateur de la figure 1 est limité en fréquences par le nombre de portes mises en cascade et le retard minimal de chaque porte. Pour augmenter la fréquence d'un tel oscillateur, on pourrait être tenté de réduire au minimum le nombre de portes inverseuses, c'est à dire à trois, voire à une porte 21 à retard variable. Avec un signal contr maximal, il serait possible d'obtenir une fréquence maximale. Des simulations sur un circuit conforme à la figure 1 avec deux portes 21, 22 rebouclées sur une entrée de la porte 16 ont montré que la plage de variation de fréquence est réduite. Il est difficile de réduire la fréquence pour l'ajuster. En diminuant la valeur du signal contr à un tiers de sa valeur maximale, les simulations ont révélé que la fréquence variait peu. En diminuant encore la valeur du signal contr, le circuit s'arrêtait d'osciller. On explique ce phénomène par le fait qu'un retard important sur la porte 21 ne laisse pas le temps au signal d'atteindre une valeur extrême haute ou basse avant que le signal in s'inverse. Lorsque le gain en boucle fermée du circuit devient inférieur à 1, celui-ci s'arrête simplement d'osciller.

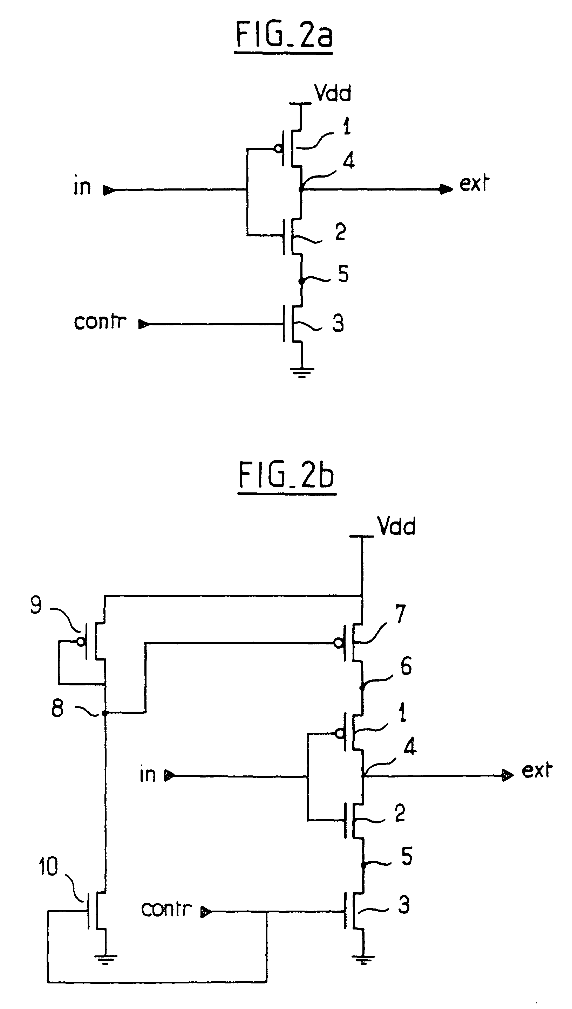

La figure 2a montre un exemple de cellule inverseuse à transistors MOS dont le signal extrait ext possède un retard τ par rapport au signal introduit in. Un transistor PMOS 1 possède une source reliée à un potentiel Vdd, une grille mise au potentiel du signal in et un drain relié à un noeud 4 dont le potentiel détermine la valeur du signal ext. Un transistor NMOS 2 possède un drain relié au noeud 4, une grille mise au potentiel du signal in et une source reliée à un noeud 5. Un transistor NMOS 3 possède un drain relié au noeud 5, une source reliée à un potentiel de masse et une grille mise au potentiel d'un signal de contrôle contr de valeur positive donnée.

Les transistors 1 et 2 sont dimensionnés de façon à avoir des caractéristiques courant-tension identiques. Une valeur du signal in proche du potentiel de masse rend passant le transistor 1 et bloquant le transistor 2. A l'état stable, le noeud 4 est chargé à une valeur de potentiel égale à Vdd.

Une valeur du signal in proche du potentiel Vdd rend bloquant le transistor 1 et passant le transistor 2. La valeur du signal contr est suffisamment positive pour que le transistor 3 soit passant. A l'état stable, le noeud 4 est déchargé à une valeur de potentiel égale au potentiel de masse.

Lorsque le signal in passe d'une valeur haute, proche du potentiel Vdd à une valeur basse, proche du potentiel de masse, la tension grille-source du transistor 1 devient égale à sa tension drain-source alors que la tension grille-source du transistor 2 s'annule, rendant ainsi bloquant le transistor 2. Un courant s'établit entre le drain et la source du transistor 1 de façon à charger le noeud 4 à une valeur haute de potentiel Vdd avec un front de montée maximal f1, fonction des caractéristiques courant-tension du transistor 1, essentiellement en régime non saturé. Pour une valeur basse du signal in, le signal ext atteint une valeur haute. Nous voyons donc que les transistors 1 et 2 se comportent comme un amplificateur inverseur dont la fonction de transfert est assimilable au premier ordre à un filtre de constante de temps minimale τ1.

Lorsque le signal in passe d'une valeur proche du potentiel de masse à une valeur proche du potentiel Vdd, la tension grille-source Vgs du transistor 1 s'annule, rendant ainsi bloquant le transistor 1, alors que la tension grille-source Vgs du transistor 2 devient égale à sa tension drain-source Vds, plaçant le transistor 2 en régime passant essentiellement non saturé. Tant que la tension drain-source Vds du transistor 3 est nettement supérieure à la valeur de potentiel du signal contr, le transistor 3 est en régime saturé et impose un courant entre le drain et la source du transistor 2, fonction de sa caractéristique courant-tension pour une tension grille-source donnée, c'est à dire fonction de la valeur du signal contr. Ceci a pour effet de décharger le noeud 4 à une valeur basse de potentiel suivant une rampe de tension jusqu'à désaturation du transistor 3. Le noeud 4 continue ensuite de se décharger pour atteindre la valeur de potentiel de masse avec une contante de temps résiduelle τ2. Pour une valeur haute du signal in, le signal ext atteint une valeur basse. Les transistors 1, 2 et 3 se comportent comme un amplificateur inverseur dont la fonction de transfert est assimilable en début de commutation à une rampe. Pour des valeurs du signal contr proches de Vdd, le transistor 3 ne fonctionne pratiquement pas en régime saturé et la fonction de transfert est assimilable au premier ordre à un filtre de constante de temps minimale d'ordre de grandeur de τ1. Plus la valeur du signal contr est faible, plus le courant de saturation du transistor 3 est faible et donc plus la partie rampée est longue avec une pente d'autant plus faible. Le signal ext possède à la descente, un retard τ par rapport à la montée du signal in. Le retard τ est d'autant plus important que la pente de la rampe est faible, c'est à dire que le signal contr est faible. Nous voyons donc qu'il est possible d'agir sur le retard de la cellule de la figure 2a en agissant sur la valeur du signal contr.

En raccordant la source du transistor 2 directement à la masse et en remplaçant le transistor 3 par un transistor PMOS de caractéristique courant-tension identique entre la source du transistor 1 et le potentiel Vdd, on observerait par symétrie de fonctionnement, un retard τ du signal ext à la montée par rapport à la descente du signal in. Il serait alors possible d'obtenir un retard τ d'autant plus faible que la valeur du signal contr sur la grille de ce transistor PMOS serait proche du potentiel de masse ou d'autant plus fort que la valeur du signal contr sur la grille de ce transistor PMOS serait proche du potentiel Vdd.

Les deux montages proposés sur le modèle de la figure 2a présentent la particularité d'avoir des fronts dissymétriques à la montée et à la descente.

La figure 2b montre un exemple de cellule permettant d'obtenir des fronts symétriques à la montée et à la descente du signal ext. On retrouve dans cette cellule les transistors 1, 2 et 3 de la cellule de la figure 2a, agencés de façon identique, à la différence près cependant que la source du transistor 1 n'est plus directement reliée au potentiel Vdd mais à un noeud intermédiaire 6. Un transistor PMOS 7 possède une source reliée au potentiel Vdd, un drain relié au noeud 6 et une grille reliée à un noeud 8. Un transistor PMOS 9 possède une source reliée au potentiel Vdd, un drain relié au noeud 8 et une grille mise au potentiel du drain du transistor 9. Un transistor NMOS 10 possède un drain relié au noeud 8, une source reliée au potentiel de masse et une grille mise au même potentiel que la grille du transistor 3. Le transistor 9 est dimensionné de façon à avoir les mêmes caractéristiques courant tension que le transistor 7 et le transistor 10 est dimensionné de façon à avoir les mêmes caractéristiques courant tension que le transistor 3.

Les tensions grille source des transistors 7 et 9, imposées par le noeud 8, étant identiques, le courant drain source du transistor 7 à l'état passant est l'image du courant drain source du transistor 9. Le potentiel du noeud 8 s'établit naturellement à un point de fonctionnement tel que le courant drain source du transistor 9 soit égal au courant drain source du transistor 10. En dimensionnant les transistors 9 et 10 de façon à avoir des caractéristiques courant tension similaires, on obtient un comportement en courant, fonction du signal contr et de la tension drain source, identique pour les transistors 3 et 7. On observe alors la même partie rampée et donc le même retard τ à la montée qu'à la descente du signal ext par rapport à la descente ou à la montée du signal in.

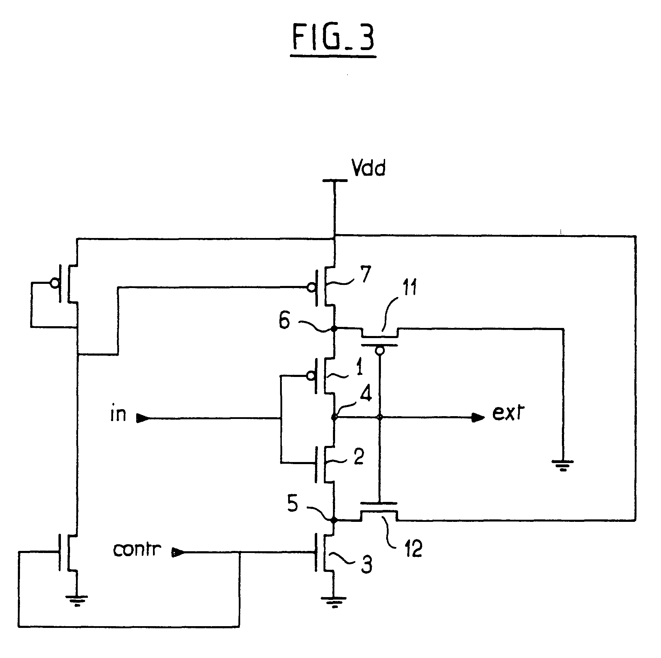

La figure 3 montre un exemple de cellule similaire à celui de la figure 2b avec les caractéristiques supplémentaires suivantes. Un transistor PMOS 11 possède une source reliée au noeud 6, un drain relié au potentiel de masse et une grille mise au potentiel du noeud 4. Un transistor NMOS 12 possède une source reliée au noeud 5, un drain relié au potentiel Vdd et une grille mise au potentiel du noeud 4.

La cellule de la figure 3 fonctionne de la façon suivante. Un état stable haut, au potentiel Vdd, du signal ext correspond à un état stable bas, au potentiel de masse, du signal in. Dans cet état, le transistor 1 est passant et le transistor 2 est bloquant. Le potentiel du noeud 4, à la valeur Vdd, end le transistor 11 bloquant, assurant ainsi le potentiel du noeud 6 à la valeur Vdd. Le potentiel du noeud 4, à la valeur Vdd, rend le transistor 12 passant, mettant ainsi le potentiel du noeud 5 à une valeur intermédiaire Vi entre le potentiel Vdd et le potentiel de masse fonction des caractéristiques courant tension des transistors 3 et 12.

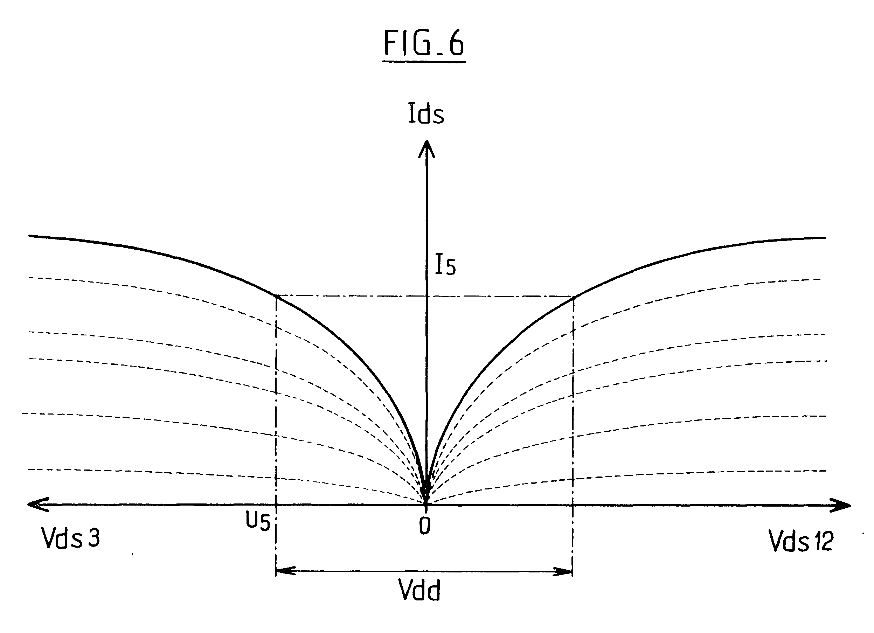

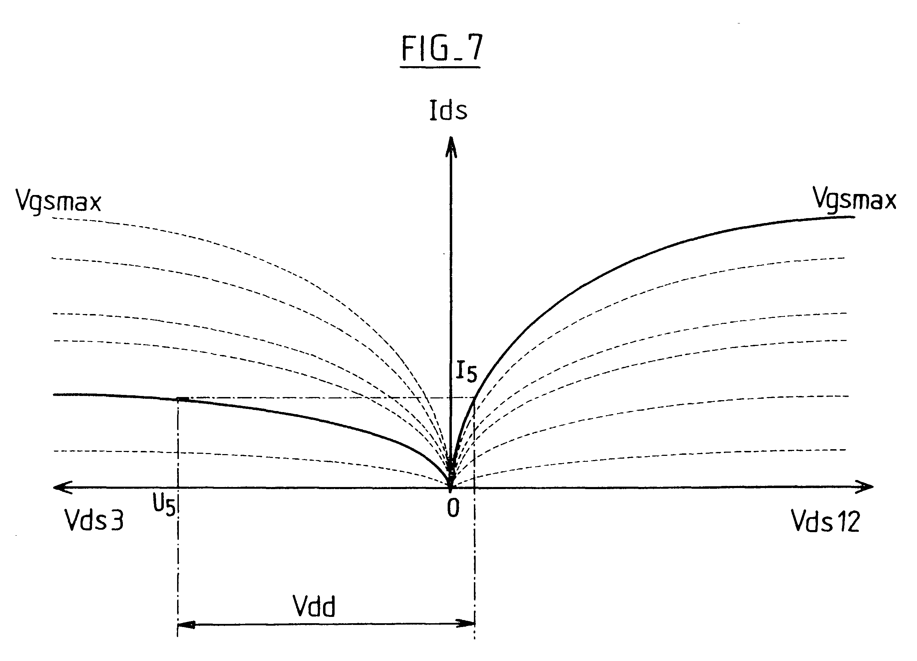

Le fonctionnement des transistors 3 et 12 sera mieux compris à l'aide des figures 6 et 7 représentant de façon shématique les caractéristiques courant tension à gauche pour le transistor 3 et à droite pour le transistor 12. A l'état stable haut du signal ext, le transistor 2 est bloqué. Le courant drain source lds, reporté en ordonnée, est identique pour les transistors 3 et 12. L'abscisse orientée vers la gauche représente la tension drain source Vds3 du transistor 3 et l'abscisse orientée vers la droite représente la tension drain source Vds12 du transistor 12. Dans chaque cadran supérieur délimité par les axes d'ordonnée et d'abscisse sont tracés différentes courbes en pointillés ou en trait plein dont chacune est caractéristique du courant lds en fonction de la tension Vds du transistor considéré, pour une valeur de tension grille source Vgs donnée. Toutes ces courbes convergent sensiblement vers 0 et possèdent une partie asymptotique à lds quasi constant pour les grandes valeurs de Vds, d'autant plus élevées que la tension Vgs est grande. La partie asymptotique correspond à l'état saturé du transistor considéré. La tension entre le drain du transistor 3 et la source du transistor 12 est constante et symbolisée par un segment de longueur Vdd. Les courbes en trait plein sont celles correspondant aux tensions Vgs à l'état stable haut du signal ext. Les intersections avec les axes lds et Vds3 d'un rectangle en traits mixtes de largeur Vdd, donnent les points de fonctionnement courant 15 et tension U5 au noeud 5.

La figure 6 donne un exemple où le signal contr est proche de Vdd. La grille du transistor 12 étant au potentiel Vdd, les tensions Vgs sont supérieures ou égales aux tensions Vds pour les deux transistors 3 et 12. Les transistors 3 et 12 fonctionnent donc en régime non saturé. La figure 6 représente un point de fonctionnement (I₅,U₅) pour des transistors 3 et 12 de caractéristiques identiques. Cependant l'explication qui suit reste valable avec des caractéristiques différentes pour les transistor 3 et 12, en décalant légèrement le rectangle en traits mixtes vers la gauche ou vers la droite.

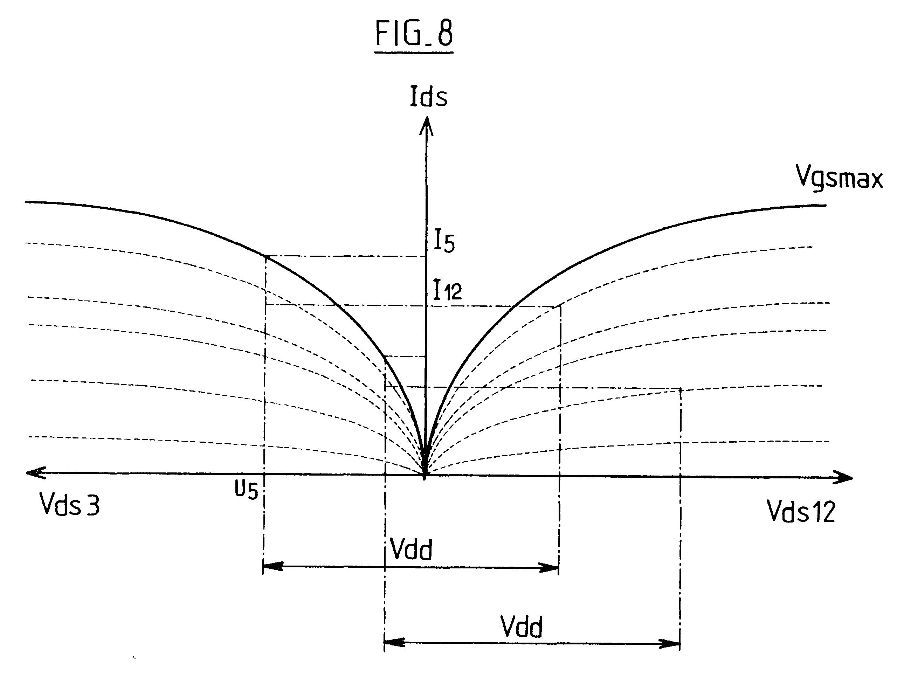

Un front raide de passage du signal in au potentiel Vdd, supérieure au potentiel du noeud 5, provoque une mise en conduction rapide du transistor 2 en régime non saturé et le blocage du transistor 1. Ici, la valeur élevée du signal contr impose au transistor 3 de rester sur sa caractéristique à Vgsmax. Sur la figure 8, on détecte deux régimes de fonctionnement du transistor 12. La figure 8 représente la superposition de deux instants de fonctionnement, un instant dans un premier régime R1 symbolisé par le segment Vdd décalé vers la gauche et un instant dans un deuxième régime R2 symbolisé par le segment Vdd décalé vers la droite.

Dans le premier régime R1, la mise en conduction du transistor 2 a pour effet de faire circuler un courant I₂ qui s'ajoute au courant I₁₂ du transistor 12 pour obtenir le courant I₅. Ceci a deux effets. Un premier effet augmente la tension Vds3 du transistor 3 pour absorber le courant supplémentaire I₂. Les points de fonctionnement ont tendance à se déplacer vers la gauche de la figure. Le deuxième effet diminue la tension du noeud 4 et fait passer le transistor 12 sur la caractéristique du régime R1 par diminution de sa tension Vgs. Cependant, comme on le voit sur la figure, le courant I₂ égal à I₅-I₁₂ reste faible et le noeud 4 se décharge lentement, restant à un niveau de potentiel proche de Vdd. Les points de fonctionnement du transistor 12 restent sur des caractéristiques proches de celle à Vgsmax en diminuant légèrement le courant I₁₂. Le transistor 12 amène donc une contre-réaction qui s'oppose à la baisse de potentiel du noeud 4. Ceci a pour résultat de maintenir le signal ext proche de la valeur haute.

Dans le deuxième régime R2, le passage du transistor 12 à des caractéristiques de Vgs plus faibles s'accélère. La tendance à déplacer les points de fonctionnement vers la gauche s'inverse. La mise en saturation du transistor 12 provoque un effet d'avalanche qui déplace brutalement les points de fonctionnement vers la droite, reportant rapidement la tension Vdd sur la tension Vds12 jusqu'à bloquer le transistor 12. On voit sur la figure 8 que les points de fonctionnement du transistor 3 sont sur la partie à fort gradient de la caractéristique. Ceci a pour effet d'amener le signal ext à sa valeur basse suivant un front raide.

Les régimes de fonctionnement présentés à l'aide des figures 6 et 8 sont ceux qui amènent les retard les plus faibles car les courants 13 sont les plus forts que l'on puisse obtenir, grâce à la valeur élevée de contr.

La figure 7 donne un exemple où le signal contr est proche du potentiel de masse. La tension grille-source du transistor 3 est faible. Le transistor 3 fonctionne en régime saturé et se comporte globalement comme une source de courant. A l'état stable haut du signal ext, la grille du transistor 12 est au potentiel Vdd. Sa tension Vgs étant du même ordre de grandeur que sa tension Vds, le transistor 12 fonctionne en régime non saturé. La figure 7 met en évidence des points de fonctionnement à gauche avec un courant I₅ faible. Une part importante de la tension Vdd est absorbée par le transistor 3. La tension drain-source du transistor 12 est faible et le potentiel du noeud 5 est proche de Vdd.

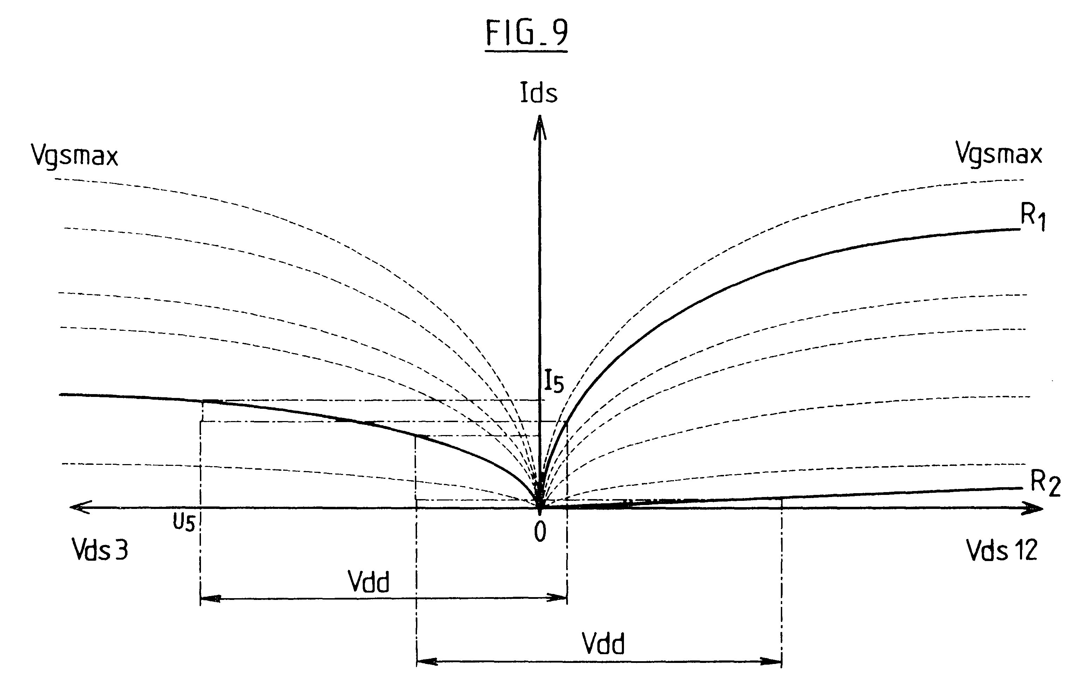

Un front raide de passage du signal in au potentiel Vdd, supérieure au potentiel du noeud 5, provoque une mise en conduction rapide du transistor 2 en régime non saturé et le blocage du transistor 1. Ici, la valeur faible du signal contr impose au transistor 3 de rester à courant pratiquement constant. Sur la figure 9, on détecte deux régimes de fonctionnement du transistor 12. La figure 9 représente la superposition de deux instants de fonctionnement, un instant dans un premier régime R1 symbolisé par le segment Vdd décalé vers la gauche et un instant dans un deuxième régime R2 symbolisé par le segment Vdd décalé vers la droite.

Dans le premier régime R1, la mise en conduction du transistor 2 a pour effet de faire circuler un courant I₂ qui s'ajoute au courant I₁₂ du transistor 12 pour obtenir le courant I₅. Ceci a deux effets. Un premier effet augmente la tension Vds3 du transistor 3 pour absorber le courant supplémentaire I₂. Les points de fonctionnement ont tendance à se déplacer vers la gauche de la figure. Le deuxième effet diminue la tension du noeud 4 et fait passer le transistor 12 sur la caractéristique du régime R1 par diminution de sa tension Vgs. Cependant, comme on le voit sur la figure, le courant I₂ égal à I₅-I₁₂ reste faible et le noeud 4 se décharge lentement, restant à un niveau de potentiel proche de Vdd. Les points de fonctionnement du transistor 12 restent sur des caractéristiques proches de celle à Vgsmax en diminuant légèrement le courant I₁₂. Le transistor 12 amène donc une contre-réaction qui s'oppose à la baisse de potentiel du noeud 4. Ceci a pour résultat de maintenir le signal ext proche de la valeur haute. Le signal ext est maintenu plus longtemps à sa valeur haute que dans l'exemple des figures 6 et 8 car le courant dans le transistor 2 est très faible à cause du comportement en source de courant du transistor 3.

Dans le deuxième régime R2, le passage du transistor 12 à des caractéristiques de Vgs plus faibles s'accélère d'autant plus aisément que celles-ci sont proches au voisinage du point 0 et que le courant I₂ du transistor 2 devient prépondérant par rapport au courant I₁₂ du transistor 12. La tendance à déplacer les points de fonctionnement vers la gauche s'inverse. La mise en saturation du transistor 12 provoque un effet d'avalanche qui déplace brutalement les points de fonctionnement vers la droite, reportant rapidement la tension Vdd sur la tension Vds12 jusqu'à bloquer le transistor 12. On voit sur la figure 9 que les points de fonctionnement du transistor 3 se rapprochent de la partie à fort gradient de la caractéristique. Ceci a pour effet d'amener le signal ext à sa valeur basse suivant un front raide.

Les régimes de fonctionnement présentés à l'aide des figures 7 et 9 sont ceux qui amènent des retard forts car les courants I₃ faibles imposent des courants I₂ faibles qui provoquent un hystérésis sur le changement d'état du signal ext. En fin d'hystérésis le changement d'état se fait avec un front raide de pente comparable à celle que l'on peut observer avec l'exemple expliqué à l'aide des figures 6 et 8.

Par symétrie, le comportement des transistors 1, 7 et 11 pour le passage du signal ext de l'état bas à l'état haut est identique au comportement des transistors 2, 3 et 12 pour le passage du signal ext de l'état haut à l'état bas. Les explications ci-dessus restent valables en reprenant les caractéristiques pour des transistors PMOS, en remplaçant le noeud 5 par le noeud 6 et les tensions Vds3, Vds12 par Vds7, Vds11.

Dans ce qui précède, les figures 6 à 9 n'ont pas la prétention de déterminer les points de fonctionnement avec la précision que donnent les équations complètes des transistors. Leur forme shématique permet d'expliquer de façon simple l'intérêt du transistor 12 ou du transistor 11.

La figure 3 présente une amélioration selon l'invention d'un exemple de cellule présenté à l'aide de la figure 2b. La mise en oeuvre du seul transistor 12 permet aussi d'améliorer un exemple de cellule présenté à l'aide de la figure 2a.

De façon simplifiée, l'enseignement de ce qui précède est le suivant. Le passage de l'état bas à l'état haut du signal in bloque le transistor 1 et débloque le transistor 2 qui décharge alors le noeud 4 pour l'amener au potentiel du noeud 5. Le transistor 12 provoque une réaction s'opposant à la baisse du potentiel du noeud 4 directement vers le potentiel de masse à travers le transistor 3. Dans une première phase, le potentiel du noeud 5 reste proche de la valeur Vi tant que le potentiel du noeud 4 reste suffisamment élevé pour maintenir passant le transistor 12. Cependant, la baisse de potentiel du noeud 4 diminue la conductivité du transistor 12 qui contribue à la baisse de potentiel du noeud 5. Dans une seconde phase, le potentiel du noeud 4 n'est plus suffisamment élevé pour maintenir une conductivité conséquente du transistor 12 et la baisse du potentiel du noeud 4 s'accélère vers le potentiel de masse, provoquant le blocage du transistor 12.

La réaction du transistor 12 provoque une cassure du front de descente du signal ext tel qu'on l'observerait avec la cellule de la figure 2b. Dans ladite première phase, le front de descente est faible et s'apparente à une hystérésis, à cause de la réaction du transistor 12 qui a tendance à maintenir le potentiel haut du noeud 4. Dans ladite seconde phase, le front de descente est fort, à cause de la disparition de la réaction du transistor 12 et au courant déjà établi dans le transistor 3.

Par symétrie de la figure 3, de façon similaire au processus précédemment décrit, les transistors 1, 7 et 11 font passer le signal ext de la valeur du potentiel de masse à la valeur du potentiel Vdd lorsque le signal in passe de la valeur du potentiel Vdd à la valeur du potentiel de masse.

Avec la cellule de la figure 3, pour obtenir un faible retard du changement d'état du signal ext sur le changement d'état du signal in, le signal contr commande une faible valeur de la résistance des transistors 3 et 7. La réaction apportée par les transistors 11 et 12 est alors faible à cause de leur valeur de résistance prépondérante sur celle des transistors 3 et 7. Le signal ext varie rapidement entre les valeurs extrêmes de potentiel de l'état initial et de l'état final.

Pour augmenter le retard du changement d'état du signal ext sur le changement d'état du signal in, le signal contr augmente la valeur de la résistance des transistors 3 et 7. La réaction apportée par les transistors 11 et 12 augmente alors à cause de leur valeur de résistance fixe dont le rapport avec celle des transistors 3 et 7 diminue. Le signal ext reste plus longtemps proche de la valeur extrême de l'état initial avant de varier rapidement vers la valeur extrême de potentiel de l'état final. Le signal ext est ainsi moins longtemps à des valeurs de potentiel intermédiaires entre les valeurs extrêmes de potentiel. Le front de changement d'états reste raide, même pour obtenir des retards importants.

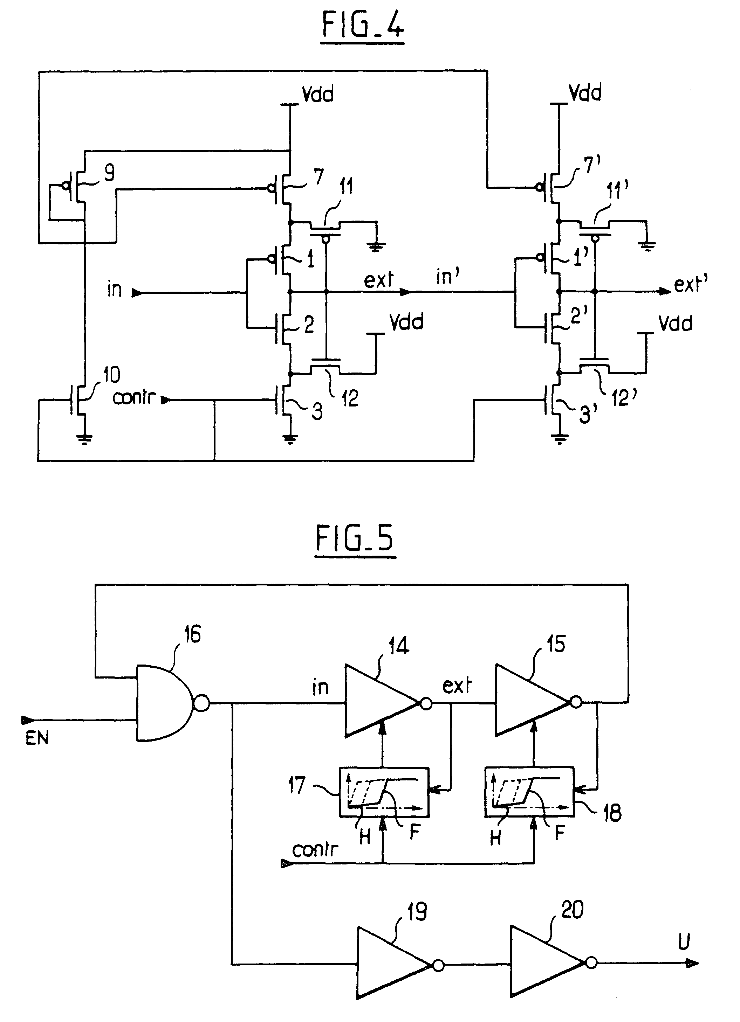

La figure 4 montre un exemple de deux cellules sur le modèle de la figure 3, montées en série. A la sortie ext d'une cellule constituée de transistors 1, 2, 3, 7, 11, 12, est connectée l'entrée in' d'une cellule constituée de transistors 1', 2', 3', 7', 11', 12'. La sortie ext' permet alors d'obtenir un retard double de celui obtenu avec une seule cellule. De même, la connexion de l'entrée in" d'une troisième cellule à la sortie ext' de la deuxième cellule permet d'obtenir un retard triple de celui obtenu avec une seule cellule. On peut donc multiplier le retard par le nombre de cellules mises bout à bout. Un seul étage miroir de courant constitué de transistors 9,10 suffit pour commander les résistances variables de toutes les cellules.

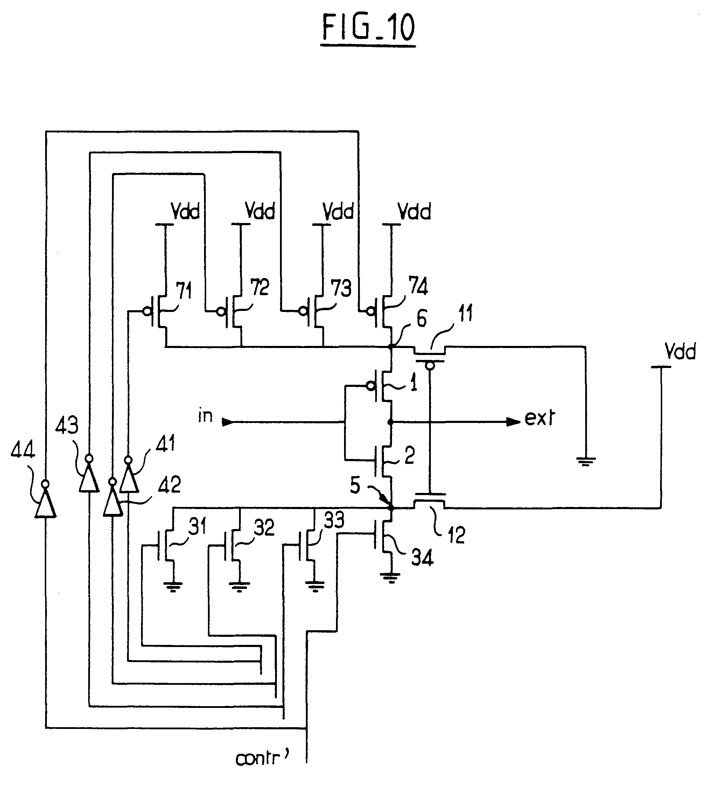

La figure 10 présente un exemple de cellule de fonctionnement similaire à celle de la figure 3, à ceci près que le transistor 3 est remplacé par plusieurs transistors 31, 32, 33, 34 branchés en parallèle entre le noeud 5 et la masse, et que le transistor 7 est remplacé par plusieurs transistors 71, 72, 73, 74 branchés en parallèle entre le noeud 6 et le potentiel Vdd. Le signal analogique contr de la figure 3 est remplacé par un signal numérique contr' codé sur un nombre de brins égal au nombre de transistors 31, 32, 33, 34. Chaque brin transmet un signal binaire, égal au potentiel Vdd ou au potentiel de masse, à la grille d'un transistor 31, 32, 33, 34. Des inverseurs 41, 42, 43, 44 permettent de transmettre le complément de chaque signal binaire à la grille d'un transistor 71, 72, 73, 74. Chaque transistor 71, 72, 73, 74 est dimensionné de façon a avoir les mêmes caractéristiques courant tension que respectivement chaque transistor 31, 32, 33, 34. Ainsi, les transistors 31, 32, 33, 34 et 71, 72, 73, 74 mis en conduction, fonctionnent en régime non saturé dont la caractéristique s'apparente à une droite de pente représentative d'une résistance équivalente. Les transistors mis en conduction par le signal numérique contr parmi les transistors 31, 32, 33, 34 définissent une valeur de résistance entre le noeud 5 et le potentiel de masse égale à la valeur de résistance entre le noeud 6 et le potentiel Vdd définie par la mise en conduction par le complément du signal contr', des transistors équivalents parmi les transistors 71, 72, 73, 74.

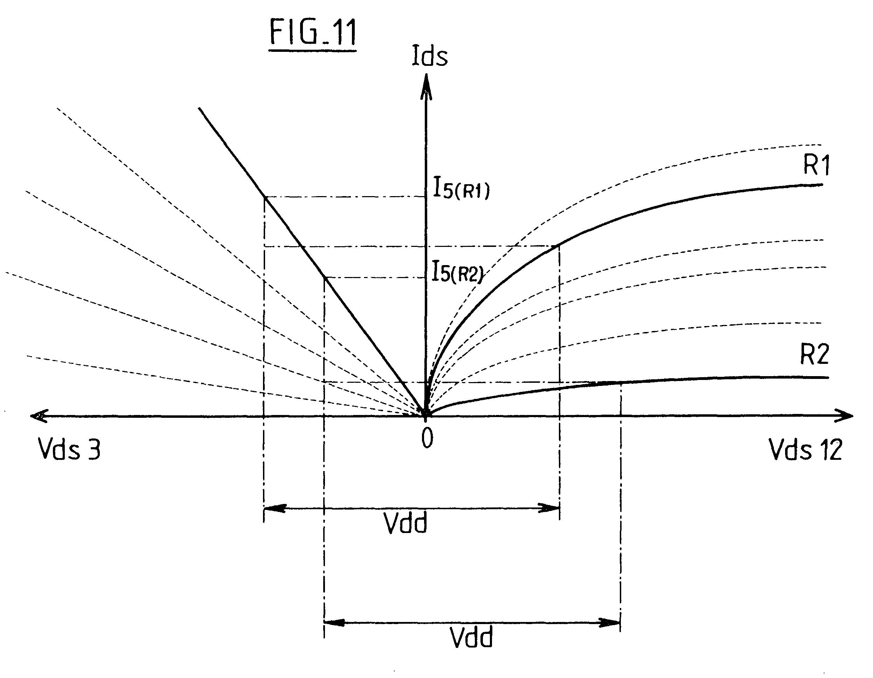

La figure 11 montre un cas où tous les brins du signal numérique contr' sont au potentiel Vdd. Tous les transistors 31, 32, 33, 34 sont mis en conduction, la résistance apparente entre le noeud 5 et le potentiel de masse est minimale. Ceci correspond à une caractéristique courant tension lds(Vds3) de coefficient directeur maximal.

Un front raide de passage du signal in au potentiel Vdd, supérieure au potentiel du noeud 5, provoque une mise en conduction rapide du transistor 2 en régime non saturé et le blocage du transistor 1. Ici, la valeur élevée du signal contr' (tous les bits à 1) impose à l'ensemble des transistors 31, 32, 33, 34 de rester sur la caractéristique linéaire en traits forts. Sur la figure 11, on détecte deux régimes de fonctionnement du transistor 12. La figure 11 représente la superposition de deux instants de fonctionnement, un instant dans un premier régime R1 symbolisé par le segment Vdd décalé vers la gauche et un instant dans un deuxième régime R2 symbolisé par le segment Vdd décalé vers la droite.

Dans le premier régime R1, la mise en conduction du transistor 2 a pour effet de faire circuler un courant I₂ qui s'ajoute au courant I₁₂ du transistor 12 pour obtenir le courant I_{5(R1)}. Ceci a deux effets. Un premier effet augmente la tension Vds3 du noeud 5 pour absorber le courant supplémentaire I₂. Les points de fonctionnement ont tendance à se déplacer vers la gauche de la figure. Le deuxième effet diminue la tension du noeud 4 et fait passer le transistor 12 sur des caractéristiques telles que la caractéristique R1 en trait fort, par diminution de sa tension Vgs. Cependant, comme on le voit sur la figure, le courant I₂ égal à I_{5(R1)}-I₁₂ reste faible et le noeud 4 se décharge lentement, restant à un niveau de potentiel proche de Vdd. Les points de fonctionnement du transistor 12 restent sur des caractéristiques proches de celle à Vgsmax en diminuant légèrement le courant I₁₂. Le transistor 12 amène donc une contre-réaction qui s'oppose à la baisse de potentiel du noeud 4. Ceci a pour résultat de maintenir le signal ext proche de la valeur haute.

Dans le deuxième régime R2, le passage du transistor 12 à des caractéristiques de Vgs plus faibles s'accélère. On voit à l'aide de la caractéristique R2 en trait fort donnant le courant I₁₂ que la différence I_{5(R2)}-I₁₂ augmente. La tendance à déplacer les points de fonctionnement vers la gauche s'inverse. La mise en saturation du transistor 12 provoque un effet d'avalanche qui déplace brutalement les points de fonctionnement vers la droite, reportant rapidement la tension Vdd sur la tension Vds12 jusqu'à bloquer le transistor 12. Ceci a pour effet d'amener le signal ext à sa valeur basse suivant un front raide.

Les régimes de fonctionnement présentés à l'aide de la figure 11 sont ceux qui amènent les retard les plus faibles car le courant I₅ est le plus fort que l'on puisse obtenir, grâce à la valeur élevée de contr' (tous les bits à 1). L'hystérésis provoquée par la contre-réaction du transistor 12 est de faible largeur.

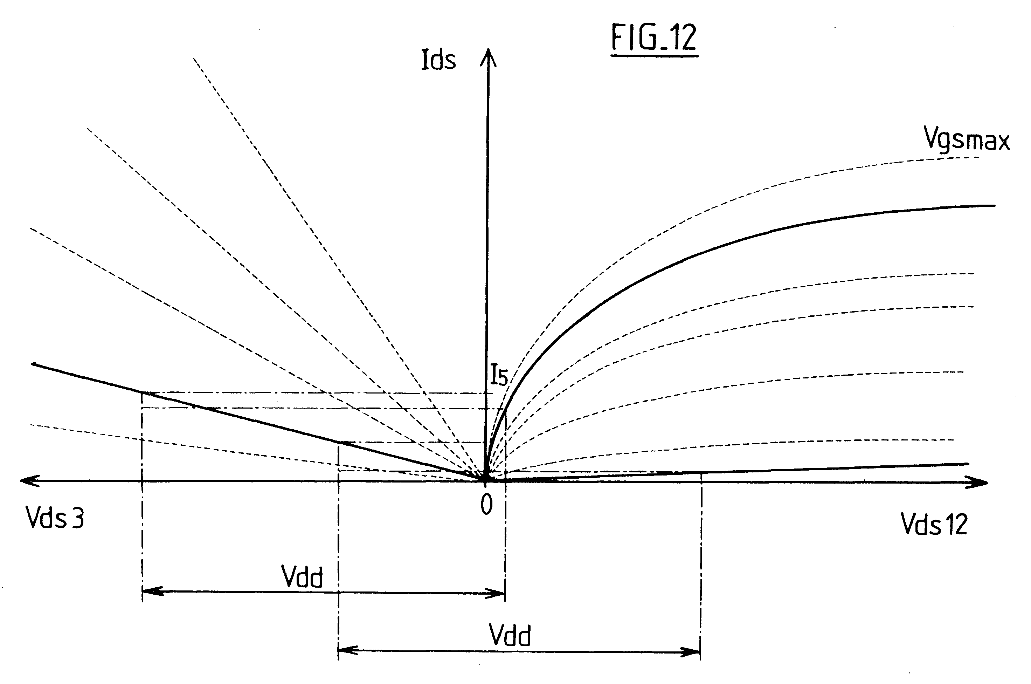

La figure 12 montre un cas où un seul brin du signal numérique contr' est au potentiel Vdd. Un seul des transistors 31, 32, 33, 34 est mis en conduction, la résistance apparente entre le noeud 5 et le potentiel de masse est maximale.

Ceci correspond à une caractéristique courant tension lds(Vds3) de coefficient directeur minimal.

Un front raide de passage du signal in au potentiel Vdd, supérieure au potentiel du noeud 5, provoque une mise en conduction rapide du transistor 2 en régime non saturé et le blocage du transistor 1. Ici, la valeur faible du signal numérique contr' impose à l'ensemble des transistors 31, 32, 33, 34 de rester sur la caractéristique linéaire lds(Vds3) en trait fort avec un coefficient directeur faible. Sur la figure 12, on détecte deux régimes de fonctionnement du transistor 12. La figure 12 représente la superposition de deux instants de fonctionnement, un instant dans un premier régime R1 symbolisé par le segment Vdd décalé vers la gauche et un instant dans un deuxième régime R2 symbolisé par le segment Vdd décalé vers la droite.

Dans le premier régime R1, la mise en conduction du transistor 2 a pour effet de faire circuler un courant I₂ qui s'ajoute au courant I₁₂ du transistor 12 pour obtenir le courant I₅. Ceci a deux effets. Un premier effet augmente la tension Vds3 entre le potentiel de masse et le noeud 5, pour absorber le courant supplémentaire I₂. Les points de fonctionnement ont tendance à se déplacer vers la gauche de la figure. Le deuxième effet diminue la tension du noeud 4 et fait passer le transistor 12 sur la caractéristique du régime R1 par diminution de sa tension Vgs. Cependant, comme on le voit sur la figure, le courant I₂ égal à I₅-I₁₂ reste faible et le noeud 4 se décharge lentement, restant à un niveau de potentiel proche de Vdd. Les points de fonctionnement du transistor 12 restent sur des caractéristiques proches de celle à Vgsmax en diminuant légèrement le courant I₁₂. Le transistor 12 amène donc une contre-réaction qui s'oppose à la baisse de potentiel du noeud 4. Ceci a pour résultat de maintenir le signal ext proche de la valeur haute. Le signal ext est maintenu plus longtemps à sa valeur haute que dans l'exemple de la figure 11 car le courant dans le transistor 2 est très faible à cause de la tension élevée du noeud 5.

Dans le deuxième régime R2, le passage du transistor 12 à des caractéristiques de Vgs plus faibles s'accélère d'autant plus aisément que celles-ci sont proches au voisinage du point 0 et que le courant I₂ du transistor 2 devient prépondérant par rapport au courant I₁₂ du transistor 12. La tendance à déplacer les points de fonctionnement vers la gauche s'inverse. La mise en saturation du transistor 12 provoque un effet d'avalanche qui déplace brutalement les points de fonctionnement vers la droite, reportant rapidement la tension Vdd sur la tension Vds12 jusqu'à bloquer le transistor 12. On voit sur la figure 12 que la quasi totalité du courant au noeud 5 est absorbée par le transistor 2. Ceci a pour effet d'amener le signal ext à sa valeur basse suivant un front raide.

Les régimes de fonctionnement présentés à l'aide de la figure 12 sont ceux qui amènent des retard forts car les courants I₃ faibles imposent des courants I₂ faibles qui provoquent un hystérésis large sur le changement d'état du signal ext. En fin d'hystérésis le changement d'état se fait avec un front raide de pente comparable à celle que l'on peut observer avec l'exemple expliqué à l'aide de la figure 11.

Par symétrie, le comportement des transistors 1, 71, 72, 73, 74 et 11 pour le passage du signal ext de l'état bas à l'état haut est identique au comportement des transistors 2, 31, 32, 33, 34 et 12 pour le passage du signal ext de l'état haut à l'état bas. Les explications ci-dessus restent valables en reprenant les caractéristiques pour des transistors PMOS, en remplaçant le noeud 5 par le noeud 6 et les tensions Vds3, Vds12 respectivement par Vds7, Vds11.

Dans ce qui précède, les figures 11 et 12 n'ont pas la prétention de déterminer les points de fonctionnement avec la précision que donnent les équations complètes des transistors. Leur forme shématique permet d'expliquer de façon simple l'intérêt du transistor 12 ou du transistor 11.

La figure 5 montre un exemple d'oscillateur à fréquence variable conforme à l'invention. Un tel oscillateur est essentiellement constitué d'un nombre impair d'inverseurs connectés en série, la sortie du dernier inverseur étant rebouclée sur l'entrée du premier. Le premier inverseur est réalisé au moyen d'une porte NON ET 16. Un deuxième et un troisième inverseur sont réalisés au moyens de cellules 14 et 15 à retard τ variable. La sortie de la cellule 15 est rebouclée sur une première entrée de la porte 16. Sur une deuxième entrée de la porte 16 est introduit un signal EN pour mettre en service l'oscillateur. Lorsque le signal EN est à 0, la sortie de la porte 16 est à 1, la sortie de la cellule 14 est alors à 0, la sortie de la porte 15 est à 1 et la sortie la porte 16 reste à 1. L'état de la boucle 16, 14, 15 est stable et le système n'oscille pas. Lorsque le signal EN monte à 1, la sortie de la porte 16 descend à 0, la sortie de la cellule 14 monte à 1 avec le retard τ et la sortie de la cellule 15 descend à 0 avec le retard τ. Si la sortie de la porte 16 change d'état avec un retard τ' sur changement d'état d'une de ses entrées, la sortie de la porte 16 monte alors à 1 avec un retard τ'. Tant que le signal EN est à 1, la première entrée de la porte 16 atteint la valeur de sa sortie avec un retard 2τ. Ceci a pour effet d'inverser la sortie de la porte 16 avec un retard 2τ+τ'. L'inversion du signal de sortie de la porte 16 avec une période T=2τ+τ' provoque l'oscillation de la boucle à une fréquence égale à 1/2T. A la sortie de la porte 16 est également branchée l'entrée d'un inverseur 17, à la sortie duquel est branchée l'entrée d'un inverseur 18. La sortie de l'inverseur 18 permet d'obtenir un signal d'utilisation U, image de la sortie de la porte 16.

Le retard d'une cellule 14, 15, est réglé par un signal de contrôle contr qui commande par un moyen 17, 18, le profile temporel du signal extrait pour une variation sur un front raide du signal d'entrée. Ce profile se décompose en deux parties. Une première partie H d'hystérésis tend à maintenir le signal extrait sur son état précédent. Une deuxième partie F de front raide amène rapidement le signal extrait sur son nouvel état.

Dans le cas des figures 3 ou 4, le moyen 17, 18, est constitué des transistors 3 et 12 si on se contente d'une amélioration de la figure 2a. Si on souhaite un comportement symétrique à la montée et à la descente, le moyen 17, 18 est constitué des transistors 3, 7, 11, 12 auxquels sont adjoints les transistors 9 et 10, communs éventuellement à plusieurs cellules. Le signal de contrôle est alors un signal contr analogique.

Dans le cas de la figure 10, le moyen 17, 18, est constitué des transistors des transistors 31, 32, 33, 34 et 12 si on se contente d'une amélioration de la figure 2a. Si on souhaite un comportement symétrique à la montée et à la descente, le moyen 17, 18 est constitué des transistors 31, 32, 33, 34, 71, 72, 73, 74, 11, 12 auxquels sont adjoints les inverseurs 41, 42, 43, 44. Pour une mise en cascade de cellules de la figure 10 sur le modèle de la figure 4, les inverseurs 41, 42, 43, 44 peuvent être communs à plusieurs cellules. Le signal de contrôle est alors un signal contr' numérique, ce qui, dans certaines applications peut présenter l'avantage d'une plus grande immunité aux bruits.

## Revendications

1. Procédé pour obtenir un signal (U) à fréquence variable au moyen d'un premier signal extrait (ext) généré par inversion d'un premier signal introduit (in) avec un retard T commandé par un signal de contrôle (contr, contr'), en répétant ladite inversion un nombre impair de fois avec, à chaque inversion, le signal extrait (ext) de l'inversion précédente comme nouveau signal introduit (in), de façon à former une boucle dans laquelle le dernier signal extrait (ext) est utilisé comme premier signal introduit (in), **caractérisé en ce que** le premier signal (ext) est obtenu à partir du signal introduit (in) avec un gain (17, 18) de valeur commandée par le signal de contrôle (contr, contr') et **en ce que** le signal extrait (ext) rétroagit sur le signal de contrôle (contr, contr') pour donner au signal extrait (ext) une hystérésis sur le changement d'état du premier signal (in), de sorte que la largeur de ladite hystérésis est fonction du signal de contrôle (contr, contr').

2. Oscillateur à fréquence variable commandée par un signal de contrôle (contr, contr'), comprenant un nombre impair de portes inverseuses (14, 15, 16) dont une entrée (in) est attaquée par une sortie (ext) d'une porte inverseuse précédente, une entrée de la première porte inverseuse (14) étant alimentée par la sortie de la dernière porte inverseuse (16), au moins une porte inverseuse (14, 15) étant constituée d'une cellule à gain (17, 18) variable en fonction du signal de contrôle (contr, contr') provoquant une hystérésis suivie d'un front raide sur la sortie pour une variation de signal sur l'entrée, **caractérisé en ce qu'**une cellule comprend :
- un amplificateur inverseur (1, 2) alimenté par un premier noeud (6) de potentiel haut et un deuxième noeud (5) de potentiel bas et dont un troisième noeud (4) constitue la sortie,
- un premier transistor (3) dont la source est reliée à un potentiel fixe inférieur au potentiel du deuxième noeud (5), dont le drain est relié au deuxième noeud (5) et dont la grille est au potentiel du signal (contr) de forme analogique, et
- un deuxième transistor (12) dont le drain est relié à un potentiel fixe égal ou supérieur au potentiel du premier noeud (6), dont la source est reliée au deuxième noeud (5) et dont la grille est au potentiel du troisième noeud (4) pour rendre passant ledit deuxième transistor (12) lorsque le potentiel du troisième noeud (4) est supérieur au potentiel du deuxième noeud (5).

3. Oscillateur à fréquence variable selon la revendication 2, **caractérisé en ce qu'**une cellule comprend en outre :
- un troisième transistor (7) dont la source est reliée à un potentiel fixe supérieur au potentiel du premier noeud (6), dont le drain est relié au premier noeud (6) et dont la grille est à un potentiel fonction du signal (contr) de forme analogique, et
- un quatrième transistor (11) dont le drain est relié à un potentiel fixe inférieur au potentiel du deuxième noeud (5), dont la source est reliée au premier noeud (6) et dont la grille est au potentiel du troisième noeud (4) pour rendre passant ledit quatrième transistor (11) lorsque le potentiel du troisième noeud (4) est inférieur au potentiel du premier noeud (6).

4. Oscillateur à fréquence variable commandée par un signal de contrôle (contr, contr'), comprenant un nombre impair de portes inverseuses (14, 15, 16) dont une entrée (in) est attaquée par une sortie (ext) d'une porte inverseuse précédente, une entrée de la première porte inverseuse (14) étant alimentée par la sortie de la dernière porte inverseuse (16), au moins une porte inverseuse (14, 15) étant constituée d'une cellule à gain (17, 18) variable en fonction du signal de contrôle (contr, contr') provoquant une hystérésis suivie d'un front raide sur la sortie pour une variation de signal sur l'entrée, **caractérisé en ce qu'**une cellule comprend:
- un amplificateur inverseur (1, 2) alimenté par un premier noeud (6) de potentiel haut et un deuxième noeud (5) de potentiel bas et dont un troisième noeud (4) constitue la sortie,
- plusieurs premiers transistors (31, 32, 33, 34) dont les sources sont reliées à un potentiel fixe inférieur au potentiel du deuxième noeud (5), dont les drains sont reliés au deuxième noeud (5) et dont chaque grille est au potentiel haut ou bas d'un brin du signal (contr') de forme numérique, et
- un deuxième transistor (12) dont le drain est relié à un potentiel fixe égal ou supérieur au potentiel du premier noeud (6), dont la source est reliée au deuxième noeud (5) et dont la grille est au potentiel du troisième noeud (4) pour rendre passant ledit deuxième transistor (12) lorsque le potentiel du troisième noeud (4) est supérieur au potentiel du deuxième noeud (5).

5. Oscillateur à fréquence variable selon la revendication 4, **caractérisé en ce qu'**une cellule comprend en outre :
- plusieurs troisièmes transistors (71, 72, 73, 74) dont les sources sont reliées à un potentiel fixe supérieur au potentiel du premier noeud (6), dont les drains sont reliés au premier noeud (6) et dont chaque grille est au potentiel inversé bas ou haut d'un brin du signal (contr') de forme numérique, et
- un quatrième transistor (11) dont le drain est relié à un potentiel fixe inférieur au potentiel du deuxième noeud (5), dont la source est reliée au premier noeud (6) et dont la grille est au potentiel du troisième noeud (4) pour rendre passant ledit troisième transistor (11) lorsque le potentiel du troisième noeud (4) est inférieur au potentiel du premier noeud (6).

6. Cellule pour obtenir un signal extrait (ext) avec un retard variable (τ) sur un signal introduit (in) au moyen d'un amplificateur inverseur dont le gain est commandé par un signal de contrôle (contr, contr'), **caractérisée en ce que** le signal extrait (ext) est obtenu à partir du signal introduit (in) avec un gain (17, 18) de valeur commandée par le signal de contrôle (contr, contr') et **en ce que** le signal extrait (ext) rétroagit sur le signal de contrôle (contr, contr') pour donner au signal extrait (ext) une hystérésis sur le changement d'état du signal introduit (in), de sorte que la largeur de ladite hystérésis est fonction du signal de contrôle (contr, contr').

7. Cellule selon la revendication 6, **caractérisée en ce qu'**elle comprend :
- un amplificateur inverseur (1, 2) alimenté par un premier noeud (6) de potentiel haut et un deuxième noeud (5) de potentiel bas et dont un troisième noeud (4) fournit le signal (ext),
- un premier transistor (3) dont la source est reliée à un potentiel fixe inférieur au potentiel du deuxième noeud (5), dont le drain est relié au deuxième noeud (5) et dont la grille est au potentiel du signal (contr) de forme analogique, et
- un deuxième transistor (12) dont le drain est relié à un potentiel fixe égal ou supérieur au potentiel du premier noeud (6), dont la source est reliée au deuxième noeud (5) et dont la grille est au potentiel du troisième noeud (4) pour rendre passant ledit deuxième transistor (12) lorsque le potentiel du troisième noeud (4) est supérieur au potentiel du deuxième noeud (5).

8. Cellule selon la revendication 7, **caractérisée en ce qu'**elle comprend en outre :
- un troisième transistor (7) dont la source est reliée à un potentiel fixe supérieur au potentiel du premier noeud (6), dont le drain est relié au premier noeud (6) et dont la grille est à un potentiel fonction du signal (contr) de forme analogique, et
- un quatrième transistor (11) dont le drain est relié à un potentiel fixe inférieur au potentiel du deuxième noeud (5), dont la source est reliée au premier noeud (6) et dont la grille est au potentiel du troisième noeud (4) pour rendre passant ledit quatrième transistor (11) lorsque le potentiel du troisième noeud (4) est inférieur au potentiel du premier noeud (6).

9. Cellule selon la revendication 6, **caractérisée en ce qu'**elle comprend :
- un amplificateur inverseur (1, 2) alimentée par un premier noeud (6) de potentiel haut et un deuxième noeud (5) de potentiel bas et dont un troisième noeud (4) fournit le signal (ext),
- plusieurs premiers transistors (31, 32, 33, 34) dont les sources sont reliées à un potentiel fixe inférieur au potentiel du deuxième noeud (5), dont les drains sont reliés au deuxième noeud (5) et dont chaque grille est au potentiel haut ou bas d'un brin du signal (contr') de forme numérique, et
- un deuxième transistor (12) dont le drain est relié à un potentiel fixe égal ou supérieur au potentiel du premier noeud (6), dont la source est reliée au deuxième noeud (5) et dont la grille est au potentiel du troisième noeud (4) pour rendre passant ledit deuxième transistor (12) lorsque le potentiel du troisième noeud (4) est supérieur au potentiel du deuxième noeud (5).

10. Cellule selon la revendication 9, **caractérisée en ce qu'**elle comprend en outre :
- plusieurs troisièmes transistors (71, 72, 73, 74) dont les sources sont reliées à un potentiel fixe supérieur au potentiel du premier noeud (6), dont les drains sont reliés au premier noeud (6) et dont chaque grille est au potentiel inversé bas ou haut d'un brin du signal (contr') de forme numérique, et
- un quatrième transistor (11) dont le drain est relié à un potentiel fixe inférieur au potentiel du deuxième noeud (5), dont la source est reliée au premier noeud (6) et dont la grille est au potentiel du troisième noeud (4) pour rendre passant ledit quatrième transistor (11) lorsque le potentiel du troisième noeud (4) est inférieur au potentiel du premier noeud (6).

## Claims

1. Method for obtaining a variable-frequency signal (U) by means of a first extracted signal (ext) generated by inversion of a first input signal (in) with a delay T controlled by a control signal (contr, contr'), repeating said inversion an odd number of times with, on each inversion, the extracted signal (ext) of the previous inversion as the new input signal (in), so as to form a loop in which the last extracted signal (ext) is used as the first input signal (in), **characterised in that** the first signal (ext) is obtained on the basis of the input signal (in) with a gain (17, 18) of a value controlled by the control signal (contr, contr') and **in that** the extracted signal (ext) feeds back to the control signal (contr, contr') to give the extracted signal (ext) a hysteresis in the change in state of the first signal (in) such that the width of said hysteresis is a function of the control signal (contr, contr').

2. Variable-frequency oscillator controlled by a control signal (contr, contr'), comprising an odd number of inverter gates (14, 15, 16), one input (in) of which is activated by an output (ext) of a previous inverter gate, one input of the first inverter gate (14) being supplied by the output of the last inverter gate (16), at least one inverter gate (14, 15) being constituted by a cell with a gain (17, 18) that is variable as a function of the control signal (contr, contr') causing a hysteresis followed by a steep edge at the output for a variation of signal on the input, **characterised in that** a cell comprises:
- an inverting amplifier (1, 2) supplied by a first high-potential node (6) and a second low-potential node (5) and for which a third node (4) constitutes the output,
- a first transistor (3), the source of which is connected to a fixed potential less than the potential of the second node (5), the drain of which is connected to the second node (5) and the gate of which is at the potential of the signal (contr) of analogue form, and
- a second transistor (12), the drain of which is connected to a fixed potential equal to or greater than the potential of the first node (6), the source of which is connected to the second node (5) and the gate of which is at the potential of the third node (4) in order to make said second transistor (12) conducting when the potential of the third node (4) is greater than the potential of the second node (5).

3. Variable-frequency oscillator according to Claim 2 **characterised in that** a cell further comprises:
- a third transistor (7), the source of which is connected to a fixed potential greater than the potential of the first node (6), the drain of which is connected to the first node (6) and the gate of which is at a potential that is a function of the signal (contr) of analogue form, and
- a fourth transistor (11), the drain of which is connected to a fixed potential less than the potential of the second node (5), the source of which is connected to the first node (6) and the gate of which is at the potential of the third node (4) in order to make said fourth transistor (11) conducting when the potential of the third node (4) is less than the potential of the first node (6).

4. Variable-frequency oscillator controlled by a control signal (contr, contr'), comprising an odd number of inverter gates (14, 15, 16), one input (in) of which is activated by an output (ext) of a previous inverter gate, one input of the first inverter gate (14) being supplied by the output of the last inverter gate (16), at least one inverter gate (14, 15) being constituted by a cell with a gain (17, 18) that is variable as a function of the control signal (contr, contr') causing a hysteresis followed by a steep edge at the output for a variation of signal on the input, **characterised in that** a cell comprises:
- an inverting amplifier (1, 2) supplied by a first high-potential node (6) and a second low-potential node (5) and for which a third node (4) constitutes the output,
- several first transistors (31, 32, 33, 34), the sources of which are connected to a fixed potential less than the potential of the second node (5), the drains of which are connected to the second node (5) and each gate of which is at the high or low potential of a strand of the signal (contr') of digital form, and
- a second transistor (12), the drain of which is connected to a fixed potential equal to or greater than the potential of the first node (6), the source of which is connected to the second node (5) and the gate of which is at the potential of the third node (4) in order to make said second transistor (12) conducting when the potential of the third node (4) is greater than the potential of the second node (5).

5. Variable-frequency oscillator according to Claim 4 **characterised in that** a cell further comprises:
- several third transistors (71, 72, 73, 74), the sources of which are connected to a fixed potential greater than the potential of the first node (6), the drains of which are connected to the first node (6) and each gate of which is at the low or high inverted potential of a strand of the signal (contr') of digital form, and
- a fourth transistor (11), the drain of which is connected to a fixed potential less than the potential of the second node (5), the source of which is connected to the first node (6) and the gate of which is at the potential of the third node (4) in order to make said third transistor (11) conducting when the potential of the third node (4) is less than the potential of the first node (6).

6. Cell for obtaining an extracted signal (ext) with a variable delay (τ) on an input signal (in) by means of an inverting amplifier, the gain of which is controlled by a control signal (contr, contr'), **characterised in that** the extracted signal (ext) is obtained on the basis of the input signal (in) with a gain (17, 18) of a value controlled by the control signal (contr, contr') and **in that** the extracted signal (ext) feeds back to the control signal (contr, contr') to give the extracted signal (ext) a hysteresis in the change in state of the input signal (in), such that the width of said hysteresis is a function of the control signal (contr, contr').

7. Cell according to Claim 6 **characterised in that** it comprises:
- an inverting amplifier (1, 2) supplied by a first high-potential node (6) and a second low-potential node (5), and for which a third node (4) supplies the signal (ext),
- a first transistor (3), the source of which is connected to a fixed potential less than the potential of the second node (5), the drain of which is connected to the second node (5) and the gate of which is at the potential of the signal (contr) of analogue form, and
- a second transistor (12), the drain of which is connected to a fixed potential equal to or greater than the potential of the first node (6), the source of which is connected to the second node (5) and the gate of which is at the potential of the third node (4) in order to make said second transistor (12) conducting when the potential of the third node (4) is greater than the potential of the second node (5).

8. Cell according to Claim 7 **characterised in that** it further comprises:
- a third transistor (7), the source of which is connected to a fixed potential greater than the potential of the first node (6), the drain of which is connected to the first node (6) and the gate of which is at a potential that is a function of the signal (contr) of analogue form, and
- a fourth transistor (11), the drain of which is connected to a fixed potential less than the potential of the second node (5), the source of which is connected to the first node (6) and the gate of which is at the potential of the third node (4) in order to make said fourth transistor (11) conducting when the potential of the third node (4) is less than the potential of the first node (6).

9. Cell according to Claim 6 **characterised in that** it comprises:
- an inverting amplifier (1, 2) supplied by a first high-potential node (6) and a second low-potential node (5) and for which a third node (4) supplies the signal (ext),
- several first transistors (31, 32, 33, 34), the sources of which are connected to a fixed potential less than the potential of the second node (5), the drains of which are connected to the second node (5) and each gate of which is at the high or low potential of a strand of the signal (contr') of digital form, and
- a second transistor (12), the drain of which is connected to a fixed potential equal to or greater than the potential of the first node (6), the source of which is connected to the second node (5) and the gate of which is at the potential of the third node (4) in order to make said second transistor (12) conducting when the potential of the third node (4) is greater than the potential of the second node (5).

10. Cell according to Claim 9 **characterised in that** it further comprises:
- several third transistors (71, 72, 73, 74), the sources of which are connected to a fixed potential greater than the potential of the first node (6), the drains of which are connected to the first node (6) and each gate of which is at the low or high inverted potential of a strand of the signal (contr') of digital form, and
- a fourth transistor (11), the drain of which is connected to a fixed potential less than the potential of the second node (5), the source of which is connected to the first node (6) and the gate of which is at the potential of the third node (4) in order to make said fourth transistor (11) conducting when the potential of the third node (4) is less than the potential of the first node (6).

## Patentansprüche

1. Verfahren zum Erhalten eines Signals (U) mit variabler Frequenz mittels eines ersten extrahierten Signals (ext), das durch Umkehrung eines ersten mit einer durch ein Steuersignal (contr, contr') gesteuerten Verzögerung T eingegebenen Signals (in) erzeugt wird, indem die Umkehrung in einer ungeraden Anzahl wiederholt wird, wobei bei jeder Umkehrung das extrahierte Signal (ext) der vorhergehenden Umkehrung als neu eingegebenes Signal (in) verwendet wird, derart, daß eine Schleife gebildet wird, in der das letzte extrahierte Signal (ext) als erstes eingegebene Signal (in) verwendet wird, **dadurch gekennzeichnet, daß** das erste Signal (ext) anhand eines eingegebenen Signals (in) mit einer Verstärkung (17, 18) mit durch das Steuersignal (contr, contr') gesteuertem Wert erhalten wird und daß das extrahierte Signal (ext) auf das Steuersignal (contr, contr') zurückwirkt, um dem extrahierten Signal (ext) bezüglich der Zustandsänderung des ersten Signals (in) eine Hysterese zu verleihen, derart, daß die Breite der Hysterese von dem Steuersignal (contr, contr') abhängt.

2. Oszillator mit variabler Frequenz, der durch ein Steuersignal (contr, contr') gesteuert wird und eine ungerade Anzahl invertierender Gatter (14, 15, 16) umfaßt, wovon jeweils ein Eingang (in) mit einem Ausgangssignal (ext) eines vorhergehenden invertierenden Gatters beaufschlagt wird, wobei ein Eingang des ersten invertierenden Gatters (14) mit dem Ausgangssignal des letzten invertierenden Gatters (16) gespeist wird, wobei wenigstens ein invertierendes Gatter (14, 15) aus einer Zelle (17, 18) mit variabler Verstärkung, die von dem Steuersignal (contr, contr') abhängt und bei einer Änderung des Eingangssignals eine Hysterese, gefolgt von einer steilen Flanke des Ausgangssignals, hervorruft, gebildet ist, **dadurch gekennzeichnet, daß** eine Zelle umfaßt:
- einen invertierenden Verstärker (1, 2), der durch einen ersten Knoten (6) mit hohem Potential und einen zweiten Knoten (5) mit niedrigem Potential gespeist wird, wobei ein dritter Knoten (4) den Ausgang bildet,
- einen ersten Transistor (3), dessen Source mit einem festen Potential, das niedriger als das Potential des zweiten Knotens (5) ist, verbunden ist, dessen Drain mit dem zweiten Knoten (5) verbunden ist und dessen Gate auf dem Potential des Signals (contr) mit analoger Form liegt,
- einen zweiten Transistor (12), dessen Drain mit einem festen Potential, das gleich wie oder höher als das Potential des ersten Knotens (6) ist, verbunden ist, dessen Source mit dem zweiten Knoten (5) verbunden ist und dessen Gate auf dem Potential des dritten Knotens (4) liegt, um den zweiten Transistor (12) durchzuschalten, wenn das Potential des dritten Knotens (4) höher als das Potential des zweiten Knotens (5) ist.

3. Oszillator mit variabler Frequenz nach Anspruch 2, **dadurch gekennzeichnet, daß** eine Zelle ferner umfaßt:
- einen dritten Transistor (7), dessen Source mit einem festen Potential, das höher als das Potential des ersten Knotens (6) ist, verbunden ist, dessen Drain mit dem ersten Knoten (6) verbunden ist und dessen Gate auf einem Potential liegt, das vom Signal (contr) mit analoger Form abhängt, und
- einen vierten Transistor (11), dessen Drain mit einem festen Potential, das niedriger als das Potential des zweiten Knotens (5) ist, verbunden ist, dessen Source mit dem ersten Knoten (6) verbunden ist und dessen Gate auf dem Potential des dritten Knotens (4) liegt, um den vierten Transistor (11) durchzuschalten, wenn das Potential des dritten Knotens (4) niedriger als das Potential des ersten Knotens (6) ist.

4. Oszillator mit variabler Frequenz, der durch ein Steuersignal (contr, contr') gesteuert wird und eine ungerade Anzahl invertierender Gatter (14, 15, 16) umfaßt, wovon jeweils ein Eingang (in) mit einem Ausgangssignal (ext) eines vorhergehenden invertierenden Gatters beaufschlagt wird, wobei ein Eingang des ersten invertierenden Gatters (14) mit dem Ausgangssignal des letzten invertierenden Gatters (16) gespeist wird, wobei wenigstens ein invertierendes Gatter (14, 15) aus einer Zelle (17, 18) mit variabler Verstärkung, die von dem Steuersignal (contr, contr') abhängt und bei einer Änderung des Eingangssignals eine Hysterese, gefolgt von einer steilen Flanke des Ausgangssignals, hervorruft, gebildet ist, **dadurch gekennzeichnet, daß** eine Zelle umfaßt:
- einen invertierenden Verstärker (1, 2), der durch einen ersten Knoten (6) mit hohem Potential und einen zweiten Knoten (5) mit niedrigem Potential gespeist wird, wobei ein dritter Knoten (4) den Ausgang bildet,
- mehrere erste Transistoren (31, 32, 33, 34), deren Sources mit einem festen Potential, das niedriger als das Potential des zweiten Knotens (5) ist, verbunden sind, deren Drains mit dem zweiten Knoten (5) verbunden sind und wovon jedes Gate auf dem hohen Potential oder dem niedrigen Potential eines Abschnitts des Signals (contr') mit digitaler Form liegt.
- einen zweiten Transistor (12), dessen Drain mit einem festen Potential, das gleich wie oder höher als das Potential des ersten Knotens (6) ist, verbunden ist, dessen Source mit dem zweiten Knoten (5) verbunden ist und dessen Gate auf dem Potential des dritten Knotens (4) liegt, um den zweiten Transistor (12) durchzuschalten, wenn das Potential des dritten Knotens (4) höher als das Potential des zweiten Knotens (5) ist.

5. Oszillator mit variabler Frequenz nach Anspruch 4, **dadurch gekennzeichnet, daß** eine Zelle ferner umfaßt:
- mehrere dritte Transistoren (71, 72, 73, 74), deren Sources mit einem festen Potential, das höher als das Potential des ersten Knotens (6) ist, verbunden sind, deren Drains mit dem ersten Knoten (6) verbunden sind und wovon jedes Gate auf dem invertierten niedrigen oder hohen Potential eines Abschnitts des Signals (contr') mit digitaler Form liegt, und
- einen vierten Transistor (11), dessen Drain mit einem festen Potential, das niedriger als das Potential des zweiten Knotens (5) ist, verbunden ist, dessen Source mit dem ersten Knoten (6) verbunden ist und dessen Gate auf dem Potential des dritten Knotens (4) liegt, um den dritten Transistor (11) durchzuschalten, wenn das Potential des dritten Knotens (4) niedriger als das Potential des ersten Knotens (6) ist.

6. Zelle zum Erhalten eines extrahierten Signals (ext) mit einer variablen Verzögerung (τ) in bezug auf ein eingegebenes Signal (in) mittels eines invertierenden Verstärkers, dessen Verstärkung durch ein Steuersignal (contr, contr') gesteuert wird, **dadurch gekennzeichnet, daß** das extrahierte Signal (ext) erhalten wird anhand des eingegebenen Signals (in) mit einer Verstärkung (17, 18) mit durch das Steuersignal (contr, contr') gesteuertem Wert und daß das extrahierte Signal (ext) auf das Steuersignal (contr, contr') zurückwirkt, um dem extrahierten Signal (ext) bezüglich der Zustandsänderung des ersten eingegebenen Signals (in) eine Hysterese zu verleihen, derart, daß die Breite der Hysterese vom Steuersignal (contr, contr') abhängt.

7. Zelle nach Anspruch 6, **dadurch gekennzeichnet, daß** sie umfaßt:
- einen invertierenden Verstärker (1, 2), der durch einen ersten Knoten (6) mit hohem Potential und einen zweiten Knoten (5) mit niedrigem Potential gespeist wird und wovon ein dritter Knoten (4) das Signal (ext) liefert,
- einen ersten Transistor (3), dessen Source mit einem festen Potential, das niedriger als das Potential des zweiten Knotens (5) ist, verbunden ist, dessen Drain mit dem zweiten Knoten (5) verbunden ist und dessen Gate auf dem Potential des Signals (contr) mit analoger Form liegt, und
- einen zweiten Transistor (12), dessen Drain mit einem festen Potential, das gleich wie oder höher als das Potential des ersten Knotens (6) ist, verbunden ist, dessen Source mit dem zweiten Knoten (5) verbunden ist und dessen Gate auf dem Potential des dritten Knotens (4) liegt, um den zweiten Transistor (12) durchzuschalten, wenn das Potential des dritten Knotens (4) höher als das Potential des zweiten Knotens (5) ist.

8. Zelle nach Anspruch 7, **dadurch gekennzeichnet, daß** sie ferner umfaßt:
- einen dritten Transistor (7), dessen Source mit einem festen Potential, das höher als das Potential des ersten Knotens (6) ist, verbunden ist, dessen Drain mit dem ersten Knoten (6) verbunden ist und dessen Gate auf einem Potential liegt, das vom Signal (contr) mit analoger Form abhängt, und
- einen vierten Transistor (11), dessen Drain mit einem festen Potential niedriger als das Potential des zweiten Knotens (5) verbunden ist, dessen Source mit dem ersten Knoten (6) verbunden ist und dessen Gate auf dem Potential des dritten Knotens (4) liegt, um den vierten Transistor (4) durchzuschalten, wenn das Potential des dritten Knotens (4) niedriger als das Potential des ersten Knotens (6) ist.

9. Zelle nach Anspruch 6, **dadurch gekennzeichnet, daß** sie umfaßt:
- einen invertierenden Verstärker (1, 2), der durch einen ersten Knoten (6) mit hohem Potential und einen zweiten Knoten (5) mit niedrigem Potential gespeist wird und wovon ein dritter Knoten (4) das Signal (ext) liefert,
- mehrere erste Transistoren (31, 32, 33, 34), deren Sources mit einem festen Potential, das niedriger als das Potential des zweiten Knotens (5) ist, verbunden sind, deren Drains mit dem zweiten Knoten (5) verbunden sind und wovon jedes Gate auf dem hohen oder niedrigen Potential eines Abschnitts des Signals (contr') mit digitaler Form liegt, und
- einen zweiten Transistor (12), dessen Drain mit einem festen Potential, das gleich wie oder höher als das Potential des ersten Knotens (6) ist, verbunden ist, dessen Source mit dem zweiten Knoten (5) verbunden ist und dessen Gate auf dem Potential des dritten Knotens (4) liegt, um den zweiten Transistor (12) durchzuschalten, wenn das Potential des dritten Knotens (4) höher als das Potential des zweiten Knotens (5) ist

10. Zelle nach Anspruch 9, **dadurch gekennzeichnet, daß** sie ferner umfaßt:
- mehrere dritte Transistoren (71, 72, 73, 74), deren Sources mit einem festen Potential, das höher als das Potential des ersten Knotens (6) ist, verbunden sind, deren Drains mit dem ersten Knoten (6) verbunden sind und wovon jedes Gate auf dem invertierten niedrigen oder hohen Potential eines Abschnitts des Signals (contr') mit digitaler Form liegt, und
- einen vierten Transistor (11), dessen Drain mit einem festen Potential, das niedriger als das Potential des zweiten Knotens (5) ist, verbunden ist, dessen Source mit dem ersten Knoten (6) verbunden ist und dessen Gate auf dem Potential des dritten Knotens (4) liegt, um den vierten Transistor (11) durchzuschalten, wenn das Potential des dritten Knotens (4) niedriger als das Potential des ersten Knotens (6) ist.
